(19) Europäisches Patentamt
European Patent Office
Office européen des brevets

(11) EP 2 058 847 A1

(12) DEMANDE DE BREVET EUROPEEN

(43) Date de publication:
13.05.2009 Bulletin 2009/20

(51) Int Cl.:
*H01L 21/335* (2006.01)  *H01L 29/775* (2006.01)
*H01L 29/76* (2006.01)  *H01L 29/06* (2006.01)
*H01L 29/786* (2006.01)

(21) Numéro de dépôt: 08168359.1

(22) Date de dépôt: 05.11.2008

(84) Etats contractants désignés:
AT BE BG CH CY CZ DE DK EE ES FI FR GB GR
HR HU IE IS IT LI LT LU LV MC MT NL NO PL PT
RO SE SI SK TR
Etats d'extension désignés:
AL BA MK RS

(30) Priorité: 09.11.2007 FR 0758933

(71) Demandeur: Commissariat à l'Energie Atomique
75015 Paris (FR)

(72) Inventeurs:
• Dornel, Erwan
  38000 Grenoble (FR)
• Barbe, Jean-Charles
  38000 Grenoble (FR)
• Ernst, Thomas
  38210 Morette (FR)

(74) Mandataire: Ilgart, Jean-Christophe et al
BREVALEX
3, rue du Docteur Lancereaux
75008 Paris (FR)

(54) **Procédé de fabrication de nanofils parallèles à leur substrat support**

(57) L'invention concerne un procédé de fabrication d'au moins un nanofil, le nanofil étant parallèle à son substrat support, le procédé comprenant :
- une étape de formation sur le substrat support d'une structure comprenant un barreau de longueur $L_{wire}$ et deux régions, une première extrémité du barreau étant solidaire de l'une des deux régions et une deuxième extrémité du barreau étant solidaire de l'autre région, la largeur du barreau étant inférieure à la largeur des régions,

- une étape de soumission du barreau à un recuit sous atmosphère gazeuse pour transformer le barreau en nanofil de rayon $r_0$, le recuit étant effectué dans des conditions permettant la formation d'au moins un pincement se produisant sur le nanofil lors de la transformation du barreau en nanofil.

Le procédé comprend une étape préliminaire consistant à déterminer les dimensions du barreau à former sur le substrat à partir du rapport $L_{wire}/r_0$, ce rapport étant inférieur à 6 si un pincement unique est désiré, ce rapport étant supérieur à 6 si un pincement double est désiré.

FIG. 8

EP 2 058 847 A1

## EP 2 058 847 A1

**Description**

**DOMAINE TECHNIQUE**

L'invention se rapporte à un procédé de fabrication de nanofils parallèles à leur substrat support. Ce procédé peut notamment s'appliquer au domaine de la micro-électronique, en particulier pour la réalisation de transistors à nanofils.

**ÉTAT DE LA TECHNIQUE ANTÉRIEURE**

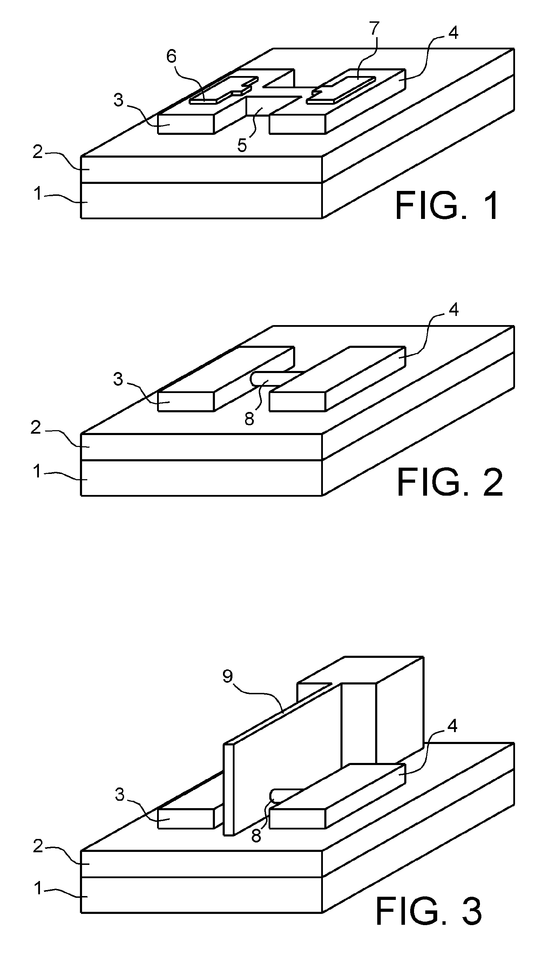

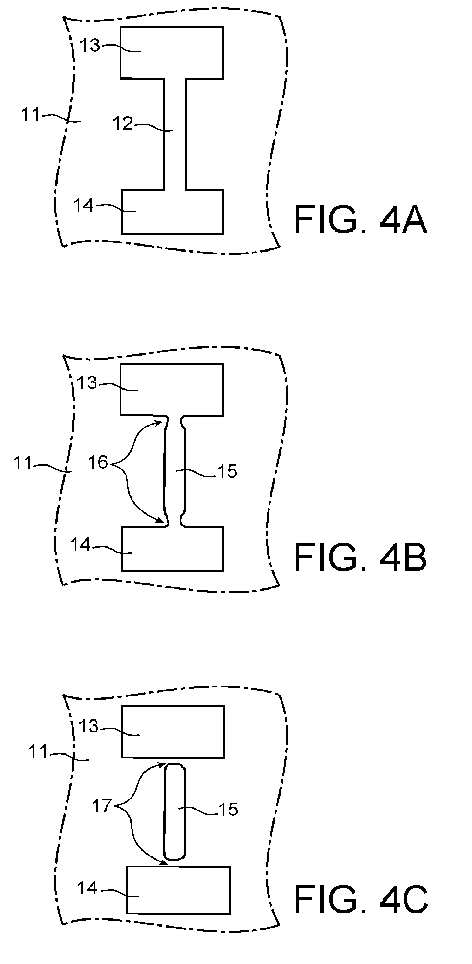

Les nanofils parallèles à leur substrat support présentent un intérêt certain pour la fabrication de transistors à effet de champ. Dans ce cas, un nanofil est lié à ses extrémités à des contacts servant d'électrodes (source et drain).
Les fils peuvent faire de quelques nanomètres de diamètre à quelques centaines de nanomètres avec un optimum à 20 nm. La longueur des fils peut aller d'une fois le diamètre à 10 fois le diamètre. Les dimensions des contacts (longueur et largeur pour un contact rectangulaire) sont supérieures à la largeur des nanofils et peuvent aller de 10 nm à plusieurs micromètres.
Le nanofil est au contact ou non avec le substrat sous-jacent, par sa partie inférieure. Dans le cas où le nanofil est au contact du substrat, on parlera d'un « nanofil sur substrat ». Dans le cas où le nanofil n'est pas au contact avec le substrat, on parlera d'un « nanofil libre ».
Dans le cas de l'application à un transistor notamment, le matériau constituant le nanofil et le matériau constituant les contacts sont semi-conducteurs monocristallins, par exemple en Si, SiGe, Ge, GaAs, AlGaAs ou amorphe. Le matériau constituant le nanofil est identique au matériau des contacts. Le substrat peut être constitué d'un monocouche ou d'un multicouche. Dans le cas d'un nanofil sur substrat, la couche supérieure du substrat est un diélectrique, par exemple du $SiO_2$ ou $Al_2O_3$. Dans le cas d'un nanofil libre, la couche supérieure du substrat peut être un diélectrique (par exemple du $SiO_2$ ou $Al_2O_3$), ou bien un conducteur ou un semi-conducteur (par exemple du Si, SiGe, Ge, GaAs ou AlGaAs ou un matériau amorphe).
Le document US 2005/0275010 divulgue un procédé de fabrication d'un transistor à nanofil. Ce transistor est fabriqué à partir d'un substrat SOI. La figure 1 montre une structure de transistor en cours de fabrication. On reconnaît le support en silicium 1 du substrat SOI et la couche d'oxyde enterré 2 et, sur cette couche d'oxyde, la structure du transistor réalisée à partir de la couche superficielle de silicium du substrat SOI dont il subsiste les parties 3, 4 et 5. La structure de transistor comprend une région de source 3, une région de drain 4 et une région de canal 5 en forme de barreau de largeur restreinte par rapport aux régions de drain et de source. Les références 6 et 7 désignent des zones d'oxyde de silicium situées respectivement sur les régions de source 3 et de drain 4. Les zones 6 et 7 proviennent du procédé de fabrication et peuvent s'étendre complètement à la surface des parties 3, 4 et 5. Les zones 6 et 7 seront éliminées par la suite.
La figure 2 montre la structure de transistor à un stade ultérieur de fabrication. Cette structure résulte d'un recuit à température élevée. Le recuit a provoqué un réarrangement des atomes de silicium. Le réarrangement est induit par une migration en surface des atomes de silicium due à la tendance à minimiser l'énergie de surface. Durant le recuit, le réarrangement des atomes au niveau de la région de canal de largeur restreinte a pour conséquence d'arrondir les coins du barreau formant la région de canal. Cette région de canal se transforme alors en un nanofil 8.
La figure 3 montre la structure de transistor complétée par la formation d'une grille 9, intercalée entre les régions de source 3 et de drain 4 et enrobant le nanofil 8.
Le recuit permet de lisser et d'arrondir la section du nanofil et d'assurer une reconstruction de la surface cristalline du nanofil afin d'en optimiser ses caractéristiques électriques. Le lissage permet de diminuer la rugosité et donc d'augmenter la mobilité des porteurs de charges électriques transitant dans le nanofil qui sert comme canal de conduction. À fort champ transversal (c'est-à-dire un champ perpendiculaire à l'axe du nanofil), les porteurs de charges interagissent avec la rugosité de l'interface entre le fil et le diélectrique de grille, ce qui dégrade leur mobilité. L'arrondissement de la section des fils permet de ne plus avoir de coin sur les fils et donc de s'affranchir du phénomène de déclenchement multiple du transistor, ce qui a pour conséquence une amélioration de la pente de la courbe $I_d(V_g)$ dite « pente sous le seuil », où $I_d$ est le courant entre les contacts de source et drain (traversant le nanofil) et $V_g$ est la tension de la grille.
Le recuit permet donc d'arrondir la section du nanofil par migration en surface des atomes de silicium. Cependant, il se produit également une migration des atomes de silicium du nanofil vers les régions de source et de drain qui sont du même matériau que le nanofil. Il peut en résulter un phénomène de pincement du nanofil (appelé « nano-wire necking » dans la terminologie anglo-saxonne).
Ce phénomène de migration est illustré par les figures 4A à 4C qui sont des vues de dessus d'un substrat 11 supportant un barreau 12 dont les extrémités sont reliées à des régions de drain 13 et de source 14. La figure 4A montre la structure avant recuit. Cette structure est donc similaire à celle de la figure 1.

Lors du recuit, comme le montre la figure 4B, il peut se produire des pincements 16 du nanofil 15 à ses deux extrémités, c'est-à-dire proche des contacts de source 13 et de drain 14. Le pincement des nanofils est un problème car il crée des résistances d'accès supplémentaires. Le pincement dégrade ainsi les performances des transistors. Le pincement peut conduire, si le recuit se poursuit, à la rupture du nanofil aux endroits référencés 17 (voir la figure 4C). Il n'y a plus alors de liaison électrique entre le nanofil 15 et les contacts de source 13 et de drain 14. Il en résulte une perte totale de la fonctionnalité du transistor.

Pour remédier à ce phénomène de pincement du nanofil, le document US 2005/0275010 préconise l'insertion d'une zone masquée sur au moins l'une des régions de source et de drain. Le masque comprend un matériau vers lequel les atomes de silicium ne migrent pas, comme le nitrure de silicium, l'oxynitrure de silicium ou l'oxyde de silicium. Puisque les atomes de silicium n'ont pas tendance à migrer vers les régions masquées, la quantité d'atomes qui migre effectivement est limitée et, par conséquent, le pincement est également limité.

La solution préconisée par le document US 2005/0275010 présente cependant l'inconvénient d'avoir à réaliser des masques sur les régions de source et de drain, ces masques pouvant être multicouches, ce qui implique des étapes supplémentaires dans le procédé de fabrication (dépôt, gravure, élimination).

Pour résumer les différents états du nanofil (ou nanobarreau) avant le recuit, selon l'art antérieur, on peut trouver :

- un nanofil sur un substrat d'un seul niveau,
- un nanofil libre d'un seul niveau, cet état nécessitant l'utilisation d'un matériau sacrificiel,
- des nanofils sur plusieurs niveaux où le fil inférieur est sur le substrat (avec une organisation matricielle),
- des nanofils sur plusieurs niveaux où le fil inférieur est libre (avec une organisation matricielle), état qui nécessite également l'utilisation d'un matériau sacrificiel.

Lors d'un recuit, un fil sur substrat restera sur le substrat, tandis qu'un fil libre restera libre.

Le document DE 10 2006 012416 A1 divulgue un procédé de fabrication d'un transistor à effet de champ comprenant la gravure et le recuit d'une région de canal en nanofil s'étendant entre les régions de source et de drain. Selon ce procédé, on évite l'apparition d'un pincement sur le nanofil grâce à un recuit sous hydrogène à une température relativement basse.

Dans l'article « Silicon single-electron transistor fabricated by anisotropic etch and oxidation » de G. PENNELLI et al., Microelectronic Engineering, Elsevier Publishers B.V., Amsterdam (Pays-Bas), vol. 83, n° 4-9, avril 2006, pages 1710 à 1713, il est divulgué un procédé de fabrication d'un transistor à un électron sur du silicium.

Un procédé de fabrication d'un transistor à boîte quantique à un électron en silicium est divulgué dans l'article « Silicon single-electron quantum-dot transistor switch operating at room temperature » de Lei Zhuang et al., Applied Physics Letters, vol. 72, n°10, 9 mars 1998, pages 1205 à 1207.

L'article « Multigate single-electron transistors and their application to an exclusive-OR gate » de Yasuo Takahashi et al., Applied Physics Letters, vol. 76, n°5, 31 janvier 2000, pages 637 à 639, divulgue des transistors multigrille à un seul electron et leur application à la fabrication d'une porte OU exclusive.

## EXPOSÉ DE L'INVENTION

Les inventeurs de la présente invention ont découvert qu'il est possible de maîtriser le dimensionnement des pincements provoqués sur les nanofils par un recuit. Il est alors possible de prévoir le dimensionnement du pincement en fonction des types de matériaux utilisés et des conditions du recuit (température de recuit, durée du recuit, nature et pression du gaz présent pendant le recuit).

L'invention a pour objet un procédé de fabrication d'au moins un nanofil, le nanofil étant parallèle à son substrat support, le procédé comprenant :

- une étape de formation sur le substrat support d'une structure comprenant un barreau de longueur $L_{wire}$ et deux régions, une première extrémité du barreau étant solidaire de l'une des deux régions et une deuxième extrémité du barreau étant solidaire de l'autre région, la largeur du barreau étant inférieure à la largeur des régions,
- une étape de soumission du barreau à un recuit sous atmosphère gazeuse pour transformer le barreau en nanofil de rayon $r_0$, le recuit étant effectué dans des conditions permettant la formation d'au moins un pincement se produisant sur le nanofil lors de la transformation du barreau en nanofil,

**caractérisé en ce que** le procédé comprend une étape préliminaire consistant à déterminer les dimensions du barreau à former sur le substrat à partir du rapport $L_{wire}/r_0$, ce rapport étant inférieur à 6 si un pincement unique est désiré, ce rapport étant supérieur à 6 si un pincement double est désiré.

Si un pincement unique est désiré, le rapport $L_{wire}/r_0$ peut être compris entre 3, 5 et 6.

Si un pincement double est désiré, le rapport $L_{wire}/r_0$ peut être compris entre 6 et 8.

Selon un autre mode de mise en oeuvre particulier, la formation sur le substrat support de la structure comprenant un barreau et deux régions provoque la création d'un évasement à chaque extrémité du barreau dans sa solidarisation avec les deux régions. L'évasement peut se faire selon un angle de 45° sur chaque bord du nanofil.

L'invention a aussi pour objet un procédé de fabrication d'au moins un transistor à nanofil, comprenant :

- la mise en oeuvre du procédé ci-dessus de fabrication d'au moins un nanofil, l'une des régions de la structure étant prévue pour constituer le drain du transistor, l'autre région de la structure étant prévue pour constituer la source du transistor,
- la formation d'au moins une grille pour le transistor sur le nanofil à l'emplacement dudit au moins un pincement.

Ce procédé de fabrication d'un transistor à nanofil permet la fabrication d'un transistor comprenant un nanofil présentant un pincement unique et une grille unique recouvrant le pincement unique. Il permet aussi la fabrication d'un transistor comprenant un nanofil présentant deux pincements et une grille unique recouvrant les deux pincements. Il permet encore la fabrication d'un transistor comprenant un nanofil présentant deux pincements et deux grilles, une première grille recouvrant un premier pincement et une deuxième grille recouvrant un deuxième pincement.

## BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1, déjà décrite, montre une structure de transistor à nanofil selon l'art connu en cours de fabrication,
- la figure 2, déjà décrite, montre la structure de transistor à nanofil de la figure 1 à un stade ultérieur de fabrication, selon l'art connu,
- la figure 3, déjà décrite, montre la structure de transistor à nanofil de la figure 2 complétée par la formation d'une grille, selon l'art connu,
- les figures 4A à 4C, déjà décrites, sont des vues de dessus d'un substrat supportant un barreau, destiné à la formation d'un nanofil, dont les extrémités sont reliées à des régions de drain et de source, illustrant le phénomène de migration des atomes du nanofil en cours de formation,
- la figure 5A reprend la structure représentée à la figure 4A et la figure 5B montre l'effet de pincement dû au recuit sur un détail de la figure 5A,
- la figure 6 est un graphe représentant la quantification du pincement en fonction du temps,
- la figure 7 représente l'algorithme du code numérique MoveFilm appliqué à un nanofil libre,
- la figure 8 est un graphe représentant la distance $L_{neck}$ entre le pincement et le contact en fonction de la longueur du nanofil et de son rayon initial $r_0$,
- la figure 9 est un diagramme représentant l'évolution du profil de la surface d'un nanofil libre pendant un recuit, en fonction du temps t, du rayon initial du nanofil $r_0$ et du coefficient B, pour $L_{wire}=6\, r_0$,
- la figure 10 est un diagramme représentant le profil de la surface d'un nanofil libre de longueur $L_{wire}=6\, r_0$, avant et après recuit pendant un temps $t=0{,}97\, r_0^4/B$,
- la figure 11 est un diagramme représentant l'évolution du profil de la surface d'un nanofil libre pendant un recuit, en fonction du temps t, du rayon initial du nanofil $r_0$ et du coefficient B, pour $L_{wire}=7\, r_0$,
- les figures 12 et 13 sont des diagrammes représentant le profil de la surface d'un nanofil libre de longueur $L_{wire}=7\, r_0$, avant et après un recuit pendant un temps $t=1{,}4\, r_0^4/B$,
- les figures 14A et 14B représentent des zones de rattachement entre des nanofils et leur contact correspondant, selon l'art connu (figure 14A) et selon l'invention (14B),
- la figure 15 est un graphe représentant le minimum du rayon du nanofil au niveau du pincement, $r_{neck}$, en fonction du temps t, du coefficient B et du rayon initial du nanofil $r_0$, pour les géométries représentées aux figures 14A et 14B.

## EXPOSÉ DÉTAILLÉ DE MODES DE RÉALISATION PARTICULIERS

La maîtrise du dimensionnement du pincement du nanofil lors du recuit s'appuie sur des simulations par l'outil numérique « MoveFilm » développé au Commissariat à l'Energie Atomique. Les bases de ce code numérique appliqué à des films sont exposées dans l'article « Surface diffusion dewetting of thin solid films : Numerical method and application to Si/SiO2 » de E. DORNEL et al., Physical Review B 73, 115 427 (2006).

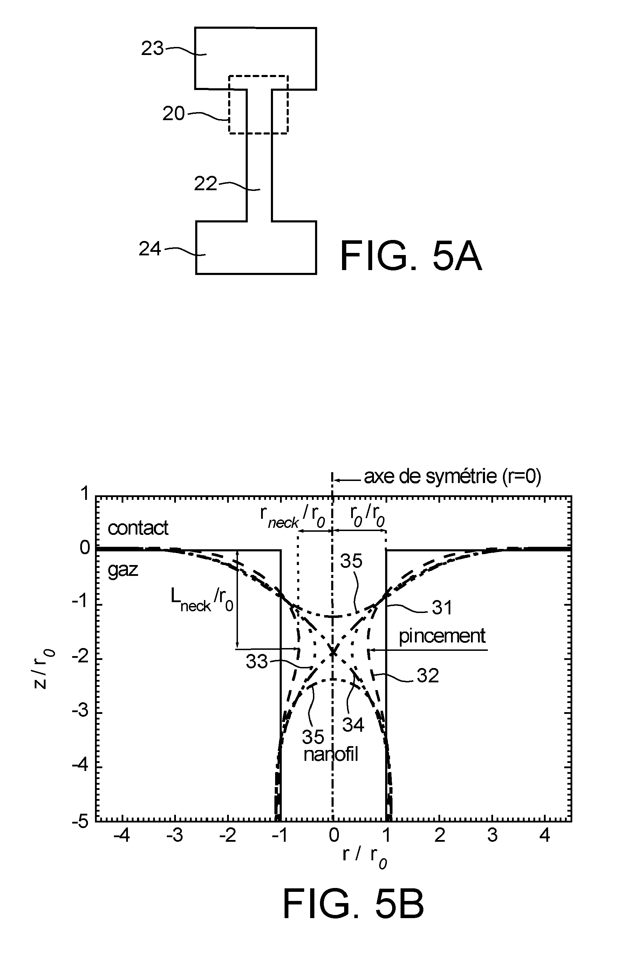

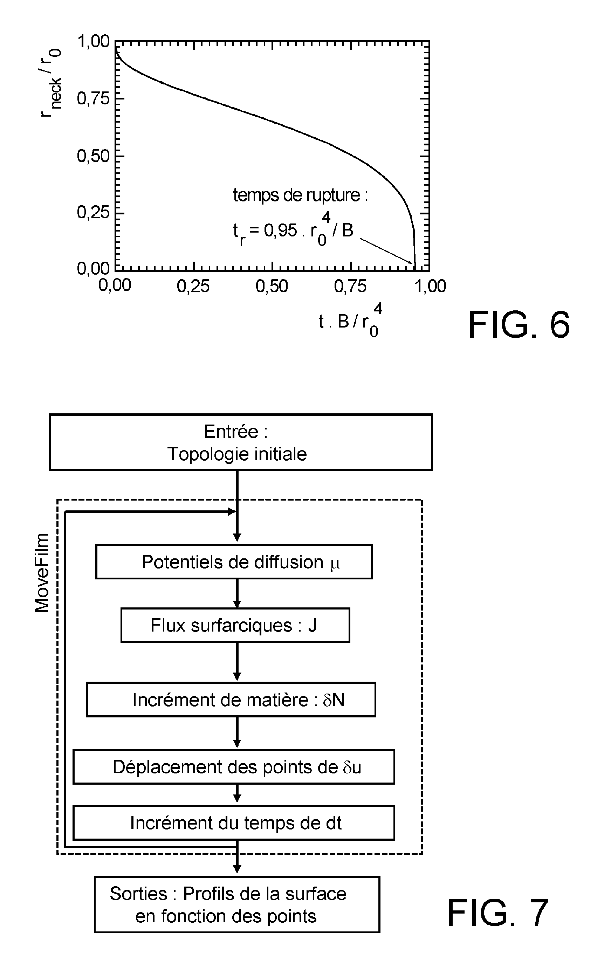

Ce code a été modifié pour pouvoir simuler les effets du recuit (arrondissement et pincement) sur des nanofils libres (présentant une symétrie de rotation) et ainsi prévoir le dimensionnement du pincement en fonction des conditions expérimentales à savoir le type de matériau et les conditions du recuit (température du recuit, temps du recuit, nature du gaz et pression du gaz). L'effet de pincement simulé par « MoveFilm » est présenté sur la figure 5B. On note $r_{neck}$ le rayon du fil au niveau du pincement (c'est le lieu du minimum du rayon du nanofil) et $L_{neck}$ la distance entre le pincement et le contact le plus proche. La quantification du pincement $r_{neck}$ en fonction du temps est présenté sur la figure 6.

Les graphes des figures 5B et 6 permettent à l'expérimentateur de dimensionner le pincement du nanofil en fonction de l'espace et du temps : les dimensions d'espace se retrouvent de façon homothétique et l'échelle de temps est donné par le facteur $B/r_0^4$, où $B=D_s.v.\gamma.\Omega^2/k_BT$, où $D_s$ est le coefficient de diffusion de surface de l'élément constituant le fil, $v$ est le nombre d'atomes de surface par unité de surface, $\gamma$ est l'énergie de surface du nanofil, $\Omega$ est le volume atomique des atomes constituant le nanofil, $k_B$ est la constante de Boltzmann et T est la température . (Si le matériau du nanofil est composé de plusieurs éléments chimiques (par exemple un alliage), les paramètres $D_s$, $v$, $\gamma$ et $\Omega$ prennent comme valeurs les valeurs du matériau composite correspondant). Par exemple, si le rayon initial du fil est multiplié par 2, le rayon minimum du fil $r_{neck}$ est multiplié par 2 et l'échelle des temps est multiplié par $2^4$ soit par 16. L'expérimentateur peut calculer le coefficient B qui est entièrement déterminé par les paramètres du matériau choisi par lui-même. Par exemple, sur la base des travaux expérimentaux de K. SUDOH et al. (« Numerical Study on Shape Transformation of Silicon Trenches by High-Temperature Hydrogen Annealing », Jap. J. of Appl. Phys., vol. 43, n°9A, 2004, pages 5937 à 5941), on peut extraire un coefficient B de 3, $8.10^{-8}$ $\mu m^4.s^{-1}$ à 800°C et de l'ordre de 4, $3.10^{-2}$ $\mu m^4.s^{-1}$ à 1100°C, pour du silicium, une atmosphère hydrogénée d'une pression de 10 Torr. Par exemple, si l'expérimentateur choisi un matériau d'énergie de surface de 1 $J.m^{-2}$, l'échelle de temps sera divisée par 2 par rapport à un matériau d'énergie de surface de 0,5 $J.m^{-2}$ (car le coefficient B est multiplié par 2). La température du recuit peut également être déterminée par l'intermédiaire du coefficient B : En supposant que le coefficient de diffusion de surface puisse s'écrire suivant la loi d'Arrhénius : $D_s=D_0.exp(-E_a/(k_B/T))$, si par exemple l'énergie d'activation $E_a$ du matériau choisi par l'utilisateur est de 2,0 eV, l'augmentation de la température de 850°C à 880°C engendre une multiplication par 2 du facteur B et donc le temps est divisé d'un facteur 2.

Au premier instant du recuit, le barreau passe d'une section carrée ou rectangulaire à une section circulaire. $r_0$ représente le rayon de la section du nanofil circulaire avant pincement. L'invention porte sur l'évolution de cette section circulaire.

La figure 5A reprend la structure représentée à la figure 4A. Elle montre un nanofil 22 en cours de formation et dont les extrémités sont reliées à des régions de drain 23 et de source 24. La référence 20 représente la zone dont l'évolution au cours du recuit est détaillée sur la figure 5B. Le même phénomène de pincement se manifeste à l'autre extrémité du nanofil à proximité du contact ou région de source 24.

La figure 5B représente le profil de la surface de l'extrémité d'un nanofil 22 libre, lié à la région de drain 23 ou contact dans le cas d'un fil libre long, obtenu à différents temps de recuit. Le trait continu 31 correspond à la surface initiale du nanofil. Le trait interrompu 32 correspond au temps $t=0,5.r_0^4/B$. Le trait interrompu 33 correspond au temps $t=0,9.r_0^4/B$. Le trait interrompu 34 correspond au temps $t=0,955.r_0^4/B$. Le trait interrompu 35 correspond au temps $t=r_0^4/B$.

Les grandeurs caractéristiques sont : $r_0$ qui représente le rayon initial du fil, $r_{neck}$ qui représente le rayon du fil au niveau de la zone de constriction (pincement) et $L_{neck}$ qui représente la distance de la zone de constriction par rapport à la position initiale du bord de la zone de contact la plus proche.

La figure 6 illustre le minimum du rayon du fil (au niveau du pincement) $r_{neck}$, en fonction du temps t, du coefficient B et du rayon initial du fil $r_0$. Ce graphe est relatif au nanofil simulé à la figure 5A. $t_r$ représente le temps où $r_{neck}=0$, c'est-à-dire quand le fil subit la rupture. L'expérimentateur peut, par ce graphe et suivant le matériau et la température du recuit qui déterminent le coefficient B, quantifier $r_{neck}$ (c'est-à-dire l'importance du pincement) et ainsi éviter la rupture du fil. Ce graphe est général pour tous matériaux de coefficient B connu. Le temps caractéristique de rupture $t_r$ s'obtient à partir des résultats ci-dessus pour $0,95\ r_0^4/B$.

On va exposer maintenant les détails du code appliqué à la simulation de l'effet de recuit des nanofils. Cet outil numérique simule l'évolution de la surface du nanofil et des contacts par diffusion de surface. Les détails du code numérique appliqué à des films sont décrits dans l'article de E. DORNEL et al. cité plus haut. On va détailler les étapes principales de l'outil numérique MoveFilm appliqué au nanofil libre présentant un axe de symétrie par rotation. La surface est discrétisée en points de coordonnées (r,z) où r est la distance à l'axe de symétrie z du nanofil. L'algorithme de ce code numérique consiste en une succession de 5 étapes : calcul des potentiels $\mu_i$ en chaque point, calcul des flux de matière $J_i$ entre chaque point $M_i$ et $M_{i+1}$, calcul des incréments de matière $\delta N_i$ attribués en chaque point $M_i$, puis les points sont déplacés et enfin le temps est incrémenté d'un pas de temps dt (voir la figure 7).

Soit $(r_{i-1}, z_{i-1})$, $(r_i, z_i)$ et $(r_{i+1}, z_{i+1})$ les coordonnées respectives des points $M_{i-1}$, $M_i$ et $M_{i+1}$ de la surface. Les calculs de ces grandeurs (c'est-à-dire potentiels, flux, incréments de matière et déplacement) ont été reformulés par rapport à l'enseignement de l'article de E. DORNEL et al. cité plus haut. Le potentiel $\mu_i$ est calculé comme le rapport de la variation de la surface sur la variation du volume, en imaginant une accrétion de matière locale au niveau du point $M_i$, soit :

$$\mu_i = 3\gamma\Omega \frac{K_{2,i}\left[\frac{r_{i+1}^2 - r_i^2}{l_i} - \frac{r_i^2 - r_{i-1}^2}{l_{i-1}} - l_i - l_{i-1}\right] + K_{1,i}\left[\frac{1}{l_i}(r_{i+1} + r_i)(z_{i+1} - z_i) - \frac{1}{l_{i-1}}(r_i + r_{i-1})(z_i - z_{i-1})\right]}{K_{2,i}[(z_{i+1} - z_i)(2r_i + r_{i+1}) + (z_i - z_{i-1})(2r_i + r_{i-1})] + K_{1,i}[(r_{i-1} - r_{i+1})(r_{i+1} + r_i + r_{i-1})]}$$

où :

$$l_i = \sqrt{(r_{i+1} - r_i)^2 + (z_{i+1} - z_i)^2}$$

$$K_{1,i} = (r_{i+1} - r_{i-1})(r_{i+1} + r_i + r_{i-1})$$

$$K_{2,i} = -2r_i(z_{i+1} - z_{i-1}) + z_i(r_{i+1} - r_{i-1}) - z_{i+1}r_{i+1} + z_{i-1}r_{i-1}$$

Le flux est proportionnel à la dérivée surfacique du potentiel, soit entre les points $M_i$ et $M_{i+1}$ :

$$J_i = -\frac{D_s\nu}{k_B T} \cdot \frac{\mu_{i+1} - \mu_i}{l_i}$$

L'incrément de matière $\delta N_i$ attribué au point $M_i$ est déterminé par la conservation de la quantité de matière, ce qui revient à l'intégrale des flux traversant les cercles de la surface de cotes $z_{i-1}$ et $z_{i+1}$ :

$$\delta N_i = \pi\left[(r_{i-1} + r_i)J_{i-1} - (r_i + r_{i+1})J_i\right]dt$$

Les points $M_i$ sont déplacés successivement, de façon à ce que ce déplacement engendre un incrément de matière égal à $\delta N_i$. De plus, les points sont déplacés perpendiculairement à la courbe iso-volume. Les points $M_i$ sont donc déplacés du vecteur ($\delta r_i, \delta z_i$) tel que :

$$\delta r_i = \frac{3\Omega\delta N_i}{\pi} \frac{N_{r,i}}{N_{z,i}K_{1,i} + N_{r,i}K_{2,i}}$$

$$\delta z_i = \frac{3\Omega\delta N_i}{\pi} \frac{N_{z,i}}{N_{z,i}K_{1,i} + N_{r,i}K_{2,i}}$$

où $(N_{r,i}, N_{z,i})$ sont les coordonnées du vecteur normal à la courbe iso-volume en $M_i$ :

$$N_{r,i} = \frac{-K_{2,i}}{\sqrt{K_{1,i}^2 + K_{2,i}^2}} \qquad \text{et} : \qquad N_{z,i} = \frac{-K_{1,i}}{\sqrt{K_{1,i}^2 + K_{2,i}^2}}$$

L'invention permet également la maîtrise de la localisation du pincement selon l'axe du nanofil, c'est-à-dire selon l'axe z.

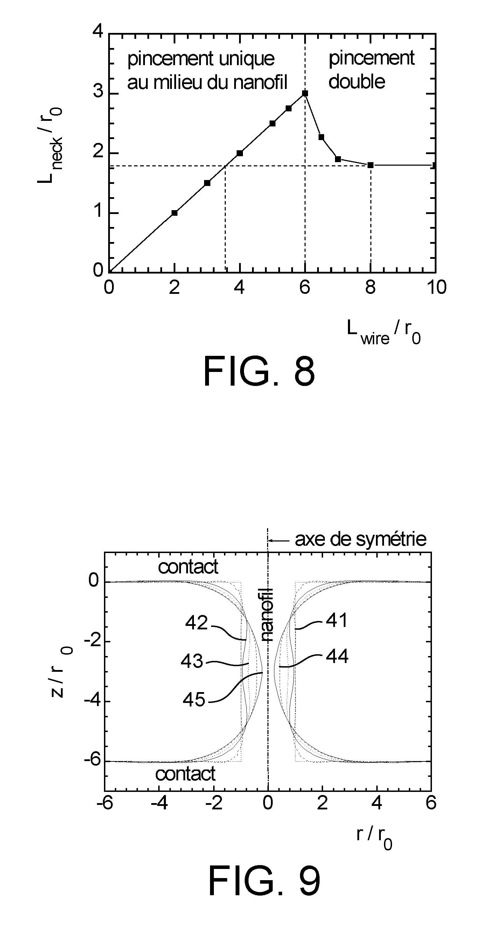

Dans le cas d'un fil long (c'est-à-dire tel que $L_{wire} > 8\ r_0$ (voir la figure 5B), le pincement se crée à une distance $L_{neck}$ égale à environ 1,9 fois le rayon initial du fil ($r_0$) correspondant au plateau atteint pour les fortes valeurs de $L_{wire}/r_0$ sur la figure 8. Cette distance $L_{neck}$ peut être ajustée en dimensionnant correctement le rapport de la longueur des fils $L_{wire}$ sur le rayon initial des fils $r_0$.

Dans la zone où $L_{wire}$ est inférieure ou égale à 6 $r_0$, le pincement est unique et est à équidistance des contacts. Cette zone est intéressante car elle permet l'alignement de la grille à équidistance des contacts, lieu où se trouve le rayon minimum du fil.

Dans le cas où $L_{wire} > 6\ r_0$, deux pincements sont créés, à proximité de chaque contact.

La zone où $3,5\ r_0 \le L_{wire} \le 8\ r_0$ est particulièrement intéressante dans la mesure où le ou les pincements créés se trouvent éloignés des contacts (c'est-à-dire $L_{neck} > 1,9\ r_0$) par rapport au cas où le fil est long (c'est-à-dire d'une longueur supérieure à 8 ro).

L'invention permet également la maîtrise de la localisation du pincement sur le nanofil. On va détailler les cas où $3,5\ r_0 \le L_{wire} \le 6\ r_0$ et où $6\ r_0 < L_{wire} \le 8\ r_0$.

**Cas où $3,5\ r_0 \le L_{wire} \le 6\ r_0$**

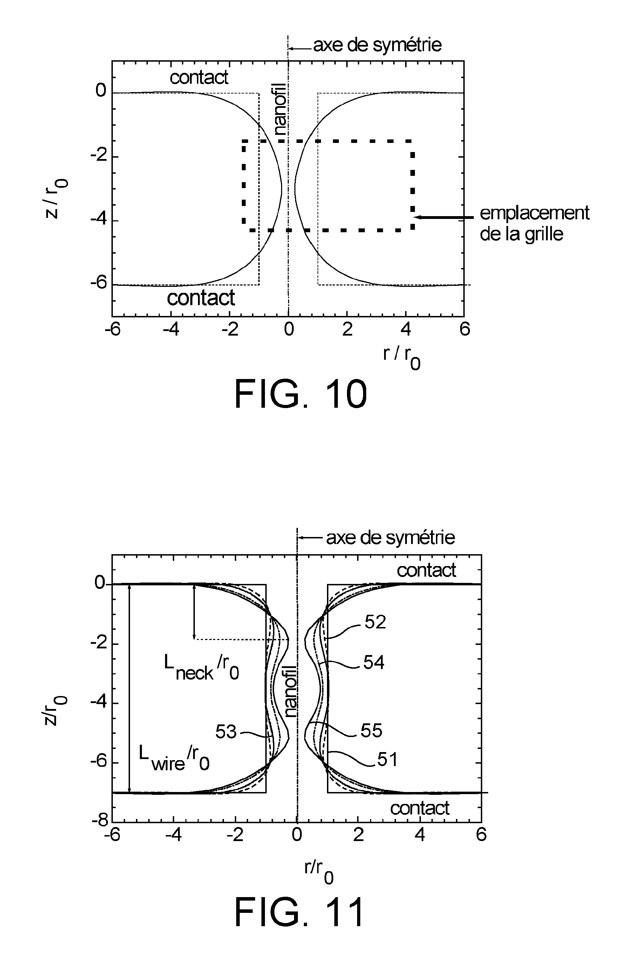

Les figures 9 et 10 donnent une illustration pour le cas $L_{neck} = 6\ r_0$. Dans la zone $3,5\ r_0 \le L_{wire} \le 6\ r_0$, le pincement est unique et est éloigné du contact par rapport au cas où $L_{wire}$ est très grand devant $r_0$. Avoir un pincement unique permet de fabriquer la grille du transistor au niveau du minimum de la largeur des fils et toujours à équidistance des contacts. De plus, le fait que le pincement soit éloigné des contacts permet de fabriquer une grille qui ne soit pas à fleur des contacts (et donc ne pas ajouter de capacités parasites), sans pour autant dégrader les résistances d'accès car le pincement se retrouve sous la grille. Typiquement, les capacités parasites évoluent selon $1/d^2$ où d est la distance entre le contact et le grille. Il est donc important d'augmenter d et donc d'augmenter $L_{neck}$. Enfin, le centre du fil, où la grille est fabriquée, présente, après recuit, un rayon plus fin qu'initialement, ce qui permet un meilleur contrôle électrostatique du courant traversant le nanofil par la grille. Par exemple, pour $L_{wire} = 6\ r_0$ et un recuit d'un temps $t = 0,97.B*r_0^4$, le minimum du rayon du nanofil est de 0,22 $r_0$ (cas de la figure 8). Par exemple, si le rayon initial vaut 10 nm, on atteindra donc au terme de ce recuit un rayon au niveau de la zone de constriction (c'est-à-dire le pincement) de 2,2 nm. La zone fine du fil permet une meilleure sensibilité après fonctionnalisation de cette zone.

Au final, on obtient un amincissement des fils au centre de l'espace situé entre les zones de source et de drain, en utilisant une technique connue qui est le recuit (voir les figures 9 et 10). Les avantages de l'invention sont donc une diminution de la cote du fil et l'alignement de la grille au niveau de ce minimum. De la sorte, le phénomène de pincement apparaît comme un avantage et non un inconvénient.

Sur la figure 9, la référence 41 désigne le profil initial du nanofil, donc pour $t.B/r_0^4 = 0$. La référence 42 désigne le profil du nanofil pour $t.B/r_0^4 = 0,3$. La référence 43 désigne le profil du nanofil pour $t.B/r_0^4 = 0,6$. La référence 44 désigne le profil du nanofil pour $t.B/r_0^4 = 0,9$. La référence 45 désigne le profil du nanofil pour $t.B/r_0^4 = 0,97$.

La figure 10 est un diagramme représentant le profil de la surface d'un nanofil libre de longueur $L_{wire} = 6\ r_0$, avant et après recuit pendant un temps $t = 0,97\ B.r_0^4$. Comme pour la figure 9, la référence 41 désigne le profil initial du nanofil et la référence 45 désigne le profil du nanofil après recuit pendant un temps $t = 0,97\ B.r_0^4$. Le positionnement optimal de la grille est indiqué par la référence 48. La grille se trouve au niveau du minimum de la largeur des fils, ce qui permet un meilleur contrôle du courant par la grille. Les parties du nanofil élargies et proches des contacts ne sont pas sous la grille, ce qui minimise les résistances d'accès.

**Cas où $6r_0 < L_{wier} \le 8\ r_0$**

La figure 11 est un diagramme représentant l'évolution du profil de la surface d'un nanofil libre pendant un recuit, en fonction du temps t, du rayon initial du nanofil $r_0$ et du coefficient B, pour $L_{wire} = 7\ r_0$.

Sur la figure 11, la référence 51 désigne le profil initial, donc pour $t.B/r_0^4 = 0$. La référence 52 désigne le profil du nanofil pour $t.B/r_0^4 = 0,1$. La référence 53 désigne le profil du nanofil pour $t.B/r_0^4 = 0,3$. La référence 54 désigne le profil du nanofil pour $t.B/r_0^4 = 1$. La référence 55 désigne le profil du nanofil pour $t.B/r_0^4 = 1,4$.

Dans la zone $6\ r_0 < L_{wire} \le 8\ r_0$, le pincement est double et est éloigné du contact par rapport au cas où $L_{wire}$ est très grand devant $r_0$. L'avantage d'avoir un $L_{neck}$ grand a déjà été discuté. L'avantage d'avoir dans ce cas deux pincements tout en ayant $L_{neck}$ grand, est de pouvoir disposer de deux zones où le fil présente un rayon réduit, pour par exemple fabriquer deux grilles indépendantes et pouvoir contrôler la quantité de courant traversant le fil.

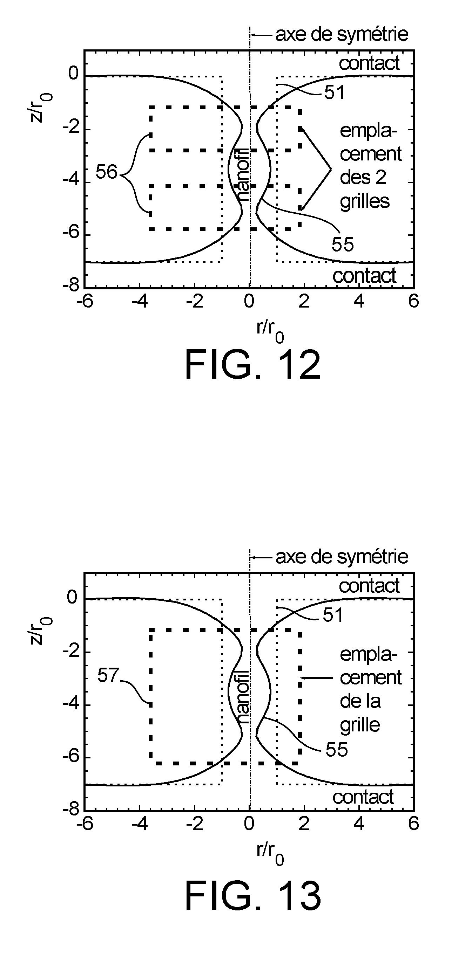

Les figures 12 et 13 sont des diagrammes représentant le profil de la surface d'un nanofil libre de longueur $L_{wire} = 7\ r_0$ et après un recuit pendant un temps $t=1{,}4\ r_0^4/B$. Sur ces figures, comme pour la figure 11, la référence 51 désigne le profil initial du nanofil et la référence 55 désigne le profil du nanofil pour $t.B/r_0^4=1{,}4$. Sur la figure 12,la référence 56 désigne les emplacements de deux grilles disposées dans un positionnement optimum. Sur la figure 13, la référence 57 désigne l'emplacement d'une grille unique disposée dans un positionnement optimum. Les grilles disposées sur les emplacements 56 et 57 enrobent la zone où le nanofil présente un rayon minimum, ce qui permet un meilleur contrôle du courant par la grille. Les parties du nanofil élargies et proches des contacts ne sont pas sous la grille, ce qui minimise les résistances d'accès.

L'avantage d'avoir deux pincements proches l'un de l'autre est de pouvoir isoler une faible quantité de matière (la matière entre les deux pincements). Fabriquer une grille unique recouvrant les deux zones de pincements permettrait d'obtenir un effet de type transistor à un ou quelques électrons (voir la figure 13).

Au final, on obtient un amincissement des nanofils au centre de l'espace situé entre les zones de source et de drain, en utilisant une technique connue qui est le recuit. Les avantages de l'invention sont donc une diminution locale de la cote du nanofil à deux endroits séparés par un endroit où le nanofil présente un rayon plus grand. De la sorte, le phénomène de pincement apparaît comme un avantage et non un inconvénient.

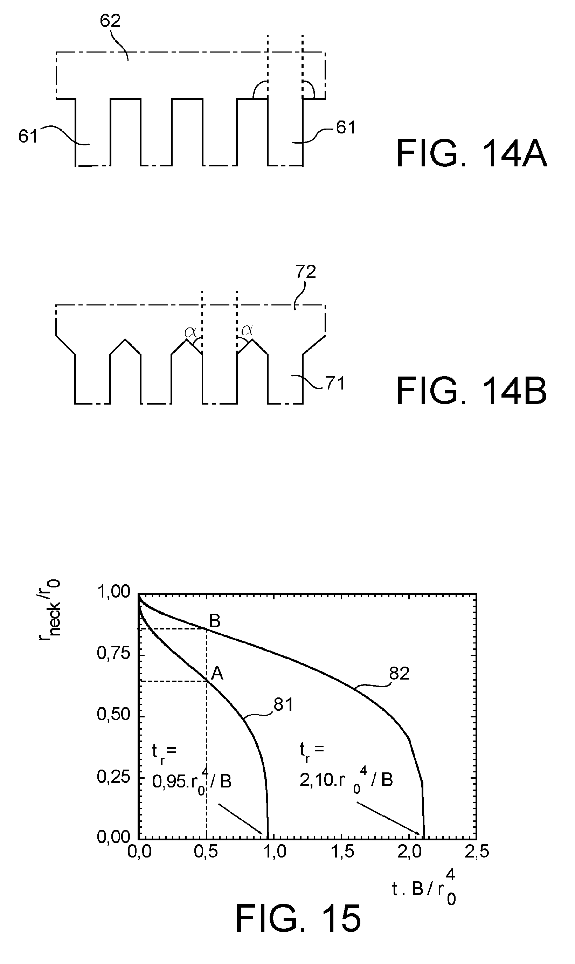

A partir des considérations précédentes et grâce à l'outil numérique utilisé par les inventeurs, ceux-ci sont parvenus à la conclusion que la modification de la courbure entre le nanofil et ses contacts permet de repousser le temps de rupture. Ceci est illustré par les figures 14A et 14B qui représentent des zones de rattachement entre des nanofils et leur contact correspondant selon l'art connu (figure 14A) et selon l'invention (figure 14B).

La figure 14A montre des nanofils 61 rattachés à leur contact 62 par un angle $\alpha$ faisant 90°. La figure 14B montre des nanofils 71 rattachés à leur contact 72 par un angle $\alpha$ faisant 45° : la forme des nanofils est donc évasée dans son raccordement avec leur contact. Dans ces conditions, le temps de rupture d'un nanofil est repoussé d'un facteur supérieur à 2 comme cela est illustré sur la figure 15.

Cette figure 15 est un graphe représentant le minimum du rayon du nanofil au niveau du pincement, $r_{neck}$, en fonction du temps t, du coefficient B et du rayon initial du nanofil $r_0$, pour les géométries représentées aux figures 14A et 14B. Le temps $t_r$ représente le temps où $r_{neck}=0$, c'est-à-dire le temps correspondant à la rupture des nanofils. On remarque que pour la géométrie représentée à la figure 14A ($\alpha=90°$), le temps de rupture est de $0{,}95\ r_0^4/B$ alors que pour la géométrie représentée à la figure 14B ($\alpha=45°$), le temps de rupture est de $2{,}10\ r_0^4/B$.

La modification de la géométrie proche des contacts permet ainsi de repousser le temps de rupture et permet à l'expérimentateur de choisir le temps et la température du recuit dans des plages moins contraignantes pour lesquelles la rupture n'est pas occasionnée par le recuit.

Un autre avantage est un gain sur la variabilité technologique. Par exemple, pour un temps de $0{,}5\ r_0^4/B$ une géométrie à 90° selon la figure 14A occasionera un pincement de $0{,}65\ r_0$, alors qu'à ce même temps, une géométrie à 45° selon la figure 14B n'occasionnera un pincement que de $0{,}85\ r_0$ (voir les points A et B sur le graphe de la figure 15).

## Revendications

**1.** Procédé de fabrication d'au moins un nanofil, le nanofil étant parallèle à son substrat support, le procédé comprenant :

- une étape de formation sur le substrat support d'une structure comprenant un barreau de longueur $L_{wire}$ et deux régions, une première extrémité du barreau étant solidaire de l'une des deux régions et une deuxième extrémité du barreau étant solidaire de l'autre région, la largeur du barreau étant inférieure à la largeur des régions,
- une étape de soumission du barreau à un recuit sous atmosphère gazeuse pour transformer le barreau en nanofil de rayon $r_0$, le recuit étant effectué dans des conditions permettant la formation d'au moins un pincement se produisant sur le nanofil lors de la transformation du barreau en nanofil,

**caractérisé en ce que** le procédé comprend une étape préliminaire consistant à déterminer les dimensions du barreau à former sur le substrat à partir du rapport $L_{wire}/r_0$, ce rapport étant inférieur à 6 si un pincement unique est désiré, ce rapport étant supérieur à 6 si un pincement double est désiré.

**2.** Procédé de fabrication selon la revendication 1, dans lequel, un pincement unique étant désiré, le rapport $L_{wire}/r_0$ est compris entre 3,5 et 6.

**3.** Procédé de fabrication selon la revendication 1, dans lequel, un pincement double étant désiré, le rapport $L_{wire}/r_0$ est compris entre 6 et 8.

**4.** Procédé de fabrication d'au moins un nanofil selon l'une quelconque des revendications 1 à 3, dans lequel la formation sur le substrat support de la structure comprenant un barreau et deux régions provoque la création d'un évasement à chaque extrémité du barreau dans sa solidarisation avec les deux régions.

**5.** Procédé de fabrication d'au moins un nanofil selon la revendication 4, dans lequel l'évasement se fait selon un angle de 45° sur chaque bord du nanofil.

**6.** Procédé de fabrication d'au moins un transistor à nanofil, comprenant :

- la mise en oeuvre du procédé selon l'une quelconque des revendications 1 à 5, l'une des régions de la structure étant prévue pour constituer le drain du transistor, l'autre région de la structure étant prévue pour constituer la source du transistor,
- la formation d'au moins une grille pour le transistor sur le nanofil à l'emplacement dudit au moins un pincement.

**7.** Transistor à nanofil réalisé par le procédé de fabrication de la revendication 6, comprenant un nanofil présentant un pincement unique et une grille unique recouvrant le pincement unique.

**8.** Transistor à nanofil réalisé par le procédé de fabrication de la revendication 6, comprenant un nanofil présentant deux pincements et une grille unique recouvrant les deux pincements.

**9.** Transistor à nanofil réalisé par le procédé de fabrication de la revendication 6, comprenant un nanofil présentant deux pincements et deux grilles, une première grille recouvrant un premier pincement et une deuxième grille recouvrant un deuxième pincement.

FIG. 1

FIG. 2

FIG. 3

13

11

12

FIG. 4A

13

11

16

15

14

FIG. 4B

13

11

17

15

14

FIG. 4C

FIG. 5A

FIG. 5B

temps de rupture :

$t_r = 0{,}95 \cdot r_0^4 / B$

FIG. 6

Entrée :
Topologie initiale

MoveFilm

Potentiels de diffusion $\mu$

Flux surfarciques : J

Incrément de matière : $\delta N$

Déplacement des points de $\delta u$

Incrément du temps de dt

Sorties : Profils de la surface
en fonction des points

FIG. 7

FIG. 8

FIG. 9

FIG. 10

FIG. 11

FIG. 12

FIG. 13

FIG. 14A

FIG. 14B

FIG. 15

**Europäisches Patentamt**

**European Patent Office**

**Office européen des brevets**

**RAPPORT DE RECHERCHE EUROPEENNE**

Numéro de la demande

EP 08 16 8359

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| D,X | US 2005/275010 A1 (CHEN HUNG-WEI [TW] ET AL) 15 décembre 2005 (2005-12-15) * figures 3,4,7e,7g * * alinéas [0029] - [0031] * ----- | 1,2,4-7 | INV. H01L21/335 H01L29/775 H01L29/76 H01L29/06 |
| X | DE 10 2006 012416 A1 (SAMSUNG ELECTRONICS CO LTD [KR]) 5 octobre 2006 (2006-10-05) * alinéa [0048] * * figures 1,2 * ----- | 1,6 | ADD. H01L29/786 |
| X | PENNELLI ET AL: "Silicon single-electron transistor fabricated by anisotropic etch and oxidation" MICROELECTRONIC ENGINEERING, ELSEVIER PUBLISHERS BV., AMSTERDAM, NL, vol. 83, no. 4-9, avril 2006 (2006-04), pages 1710-1713, XP005426921 ISSN: 0167-9317 paragraphe 4 : "preliminary electrical characterization" * figure 4 * ----- | 8 | |
| | | | DOMAINES TECHNIQUES RECHERCHES (IPC) |
| X | ZHUANG LEI ET AL: "Silicon single-electron quantum-dot transistor switch operating at room temperature" APPLIED PHYSICS LETTERS, AIP, AMERICAN INSTITUTE OF PHYSICS, MELVILLE, NY, US, vol. 72, no. 10, 9 mars 1998 (1998-03-09), pages 1205-1207, XP012019779 ISSN: 0003-6951 * figure 1 * ----- -/-- | 8 | H01L |

Le présent rapport a été établi pour toutes les revendications

| Lieu de la recherche | Date d'achèvement de la recherche | Examinateur |
|---|---|---|
| Munich | 26 janvier 2009 | Moehl, Sebastian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 08 16 8359

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | TAKAHASHI YASUO ET AL: "Multigate single-electron transistors and their application to an exclusive-OR gate" APPLIED PHYSICS LETTERS, AIP, AMERICAN INSTITUTE OF PHYSICS, MELVILLE, NY, US, vol. 76, no. 5, 31 janvier 2000 (2000-01-31), pages 637-639, XP012025796 ISSN: 0003-6951 * page 638 * * figure 3 * ----- | 9 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 26 janvier 2009 | Moehl, Sebastian |

CATEGORIE DES DOCUMENTS CITES

X : particulièrement pertinent à lui seul
Y : particulièrement pertinent en combinaison avec un
 autre document de la même catégorie
A : arrière-plan technologique
O : divulgation non-écrite
P : document intercalaire

T : théorie ou principe à la base de l'invention
E : document de brevet antérieur, mais publié à la
 date de dépôt ou après cette date
D : cité dans la demande
L : cité pour d'autres raisons

........................................................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 16 8359

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-01-2009

| Document brevet cité<br>au rapport de recherche | Date de<br>publication | Membre(s) de la<br>famille de brevet(s) | Date de<br>publication |
|---|---|---|---|
| US 2005275010 A1 | 15-12-2005 | TW 282582 B | 11-06-2007 |
| DE 102006012416 A1 | 05-10-2006 | JP 2006270107 A | 05-10-2006 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050275010 A

- DE 102006012416 A1

**Littérature non-brevet citée dans la description**

- Silicon single-electron transistor fabricated by anisotropic etch and oxidation. **G. PENNELLI et al.** Microelectronic Engineering. Elsevier Publishers B.V, Avril 2006, vol. 83, 1710-1713
- **LEI ZHUANG et al.** Silicon single-electron quantum-dot transistor switch operating at room temperature. *Applied Physics Letters,* 09 Mars 1998, vol. 72 (10), 1205-1207
- **YASUO TAKAHASHI et al.** Multigate single-electron transistors and their application to an exclusive-OR gate. *Applied Physics Letters,* 31 Janvier 2000, vol. 76 (5), 637-639

- **E. DORNEL et al.** Surface diffusion dewetting of thin solid films : Numerical method and application to Si/SiO. *Physical Review B,* 2006, vol. 73, 115 427
- **K. SUDOH et al.** Numerical Study on Shape Transformation of Silicon Trenches by High-Temperature Hydrogen Annealing. *J. of Appl. Phys.,* 2004, vol. 43 (9A), 5937-5941